Europäisches Patentamt

European Patent Office

Office européen des brevets

(11) Publication number: **0 068 753**
**B1**

(12) **EUROPEAN PATENT SPECIFICATION**

(45) Date of publication of patent specification: **30.09.87**

(21) Application number: **82303178.6**

(22) Date of filing: **18.06.82**

(51) Int. Cl.⁴: **H 01 L 25/16, H 01 L 23/04,**
**H 01 L 23/14, H 01 L 23/56**

(54) **Hybrid integrated circuit device.**

(30) Priority: **25.06.81 JP 94877/81 u**

(43) Date of publication of application:
**05.01.83 Bulletin 83/01**

(45) Publication of the grant of the patent:
**30.09.87 Bulletin 87/40**

(84) Designated Contracting States:
**DE FR GB**

(56) References cited:
**US-A-3 665 592**
**US-A-3 882 323**
**US-A-4 208 698**

**IEEE TRANSACTIONS ON COMPONENTS,**
**HYBRIDS, AND MANUFACTURING**
**TECHNOLOGY, vol. CHMT-2, no. 2, June 1979,**
**pages 208-217, IEEE, New York, US; T. KAMEI**
**et al.: "Hybrid IC structures using solder reflow**
**technology"**

**PATENTS ABSTRACTS OF JAPAN, vol. 5, no.**
**70 (E-56)742r, 12th May 1981; & JP - A - 56 21**
**349 (FUJITSU K.K.) 27-02-1981**

(73) Proprietor: **FUJITSU LIMITED**
**1015, Kamikodanaka Nakahara-ku**
**Kawasaki-shi Kanagawa 211 (JP)**

(72) Inventor: **Akasaki, Hidehiko**
**1-633, Marukodori Nakahara-ku**
**Kawasaki-shi Kanagawa 211 (JP)**

(74) Representative: **George, Sidney Arthur et al**
**GILL JENNINGS & EVERY 53-64 Chancery Lane**
**London WC2A 1HN (GB)**

(56) References cited:
**CHEMICAL ABSTRACTS, vol. 85, no. 12, 1976,**
**page 552, no. 85961s, Columbus, Ohio, US; Y.**
**TAKETA et al.: "Composition and electrical**
**properties of ruthenium(IV) oxide thick film**
**resistors" & NIPPON DAIGAKU SEISAN**
**KOGAKUBU KOGOKU 1975, 8(1), 17-24**
**PATENTS ABSTRACTS OF JAPAN, vol. 6, no.**
**140 (E-121)1018r, 29th July 1982; & JP - A - 57**
**64 953 (OKI DENKI KOGYO K.K.) 20-04-1982**

## Description

This invention relates to a hybrid integrated circuit device comprising, in combination, a semiconductor integrated circuit element and one or more resistors.

In a prior art hybrid device comprising active elements, such as transistors, and passive elements, such as resistors, firstly film resistors are printed on a circuit board, and then transistor elements and the like are bonded, by soldering, to the same board.

In recent years, active elements have been manufactured as a semiconductor integrated circuit element and, at the same time, the printed board has been made of ceramic material so as to enhance the reliability of the hybrid integrated circuit device. In addition, the semiconductor integrated circuit element is housed in a ceramic package. In this case, since the integration density of the semiconductor integrated circuit element has become high and, accordingly, the number of connection terminals has increased, a multilayer ceramic package in which complex conductive layers are formed has been made.

In the above-mentioned prior art, however, since film resistors are formed on the printed board, the device is large and, in addition, testing cannot be carried out on only the package including the semiconductor integrated circuit element without such a board.

On the other hand, due to the development of such a semiconductor integrated circuit element used for a hybrid device, the resistance value of film resistors connected to the semiconductor circuit element cannot be fixed and, accordingly, function trimming is desired in order to obtain the optimum resistance value of the film resistors. However, it is difficult to carry out such function trimming on the film resistors formed on the board on which, in this case, the package including the semiconductor integrated circuit element must be mounted.

US—A—4 208 699 discloses a hybrid circuit structure in which thick-film resistors are formed on a first ceramic substrate, whereas a second ceramic substrate supports the integrated circuits and thin-film resistor and capacitor elements. The two substrate assemblies are bonded together, and the resulting structure is enclosed in a hermetic package.

According to the present invention, a hybrid integrated circuit device comprising a semiconductor integrated circuit element mounted within a multilayer ceramic package is characterised in that the package includes a first frame member creating a cavity for incorporating the semiconductor circuit element therein, a cap mounted on the first frame member so as to seal the cavity, and a second frame member mounted on the first frame member and surrounding the cap, the cap being thinner than the second frame member; external connection terminals are mounted on the back of the multilayer ceramic package; a base is mounted on the second frame member; and a film resistor pattern is formed on the outer surface of the base and electrically connected to the semiconductor circuit element, the film resistor pattern being trimmed so that the resistance value of the film resistor pattern is adapted to the characteristics of the semiconductor circuit element.

An embodiment of the present invention will now be described, by way of example, with reference to the accompanying drawings, wherein:

Fig. 1 is a cross-sectional view illustrating an embodiment of the hybrid semiconductor device according to the present invention;

Fig. 2 is a plan view of the device of Fig. 1; and

Fig. 3 is an enlargement of part of the device of Fig. 2 for explaining a function trimming method.

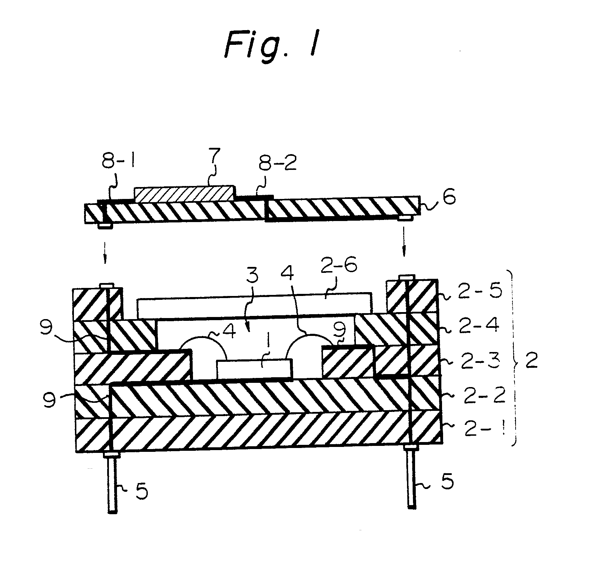

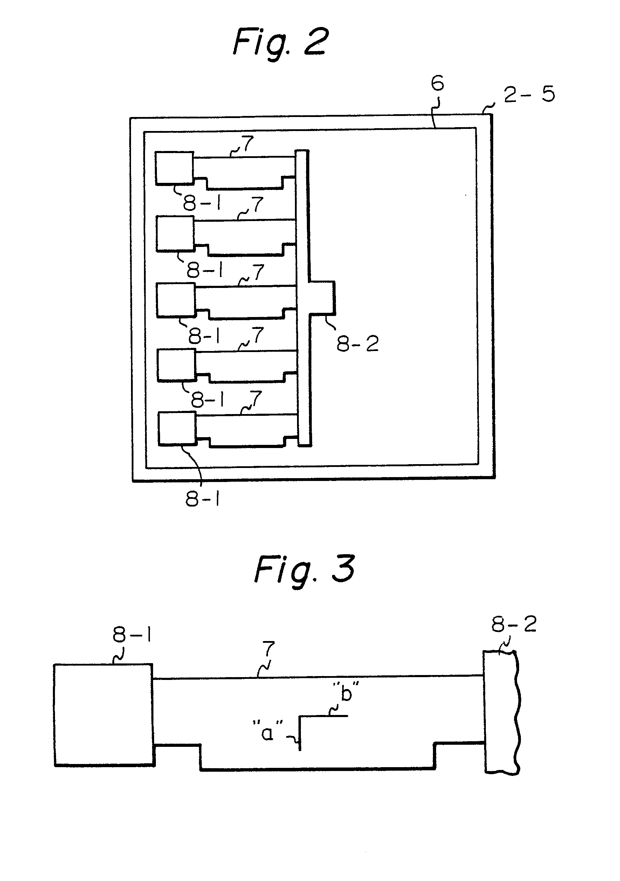

In Figs. 1 and 2, a semiconductor integrated circuit element (chip) 1 is incorporated into a multilayer ceramic package 2 which comprises, for example, five ceramic layers 2-1 to 2-5 and a ceramic or metal cap 2—6. The ceramic layers 2—4 and 2—5 are frame-shaped, and the ceramic layer 2—5 and the cap 2—6 are mounted on the ceramic layer 2—4. In this case, the cap 2—6 is surrounded by the ceramic layer 2—5, and, in addition, the cap 2—6 is thinner than the ceramic layer 2—5. The semiconductor integrated circuit element 1 is located within a sealed cavity 3 and is connected by bonding wires 4 to metallised layers which are connected to external connection terminals 5.

A thick film resistor pattern 7 is formed on a base 6. The thick film resistor pattern 7 is connected to conductive layers 8—1 and 8—2 formed by coating the base 6 with Pd/Ag paste and then firing it.

Conductive layers 9 within the multilayer ceramic package 2 are formed by coating the surface or throughholes of a raw ceramic sheet with a layer of molybdenummanganese or tungsten, thereby laminating the raw ceramic sheets which are then fired at a high temperature in a reducing atmosphere including hydrogen gas. Therefore, the package 2 cannot be fired in an oxidising atmosphere. On the other hand, the base 6 is made of ceramic material or glass, and the thick film resistor pattern 7 is made of, for example, a mixture of oxide such as ruthenium oxide and glass powder. Hence, the pattern 7 must be manufactured by coating the base 6 with such a mixture and then firing it in an oxidising atmosphere.

Therefore, the two portions, i.e. the package portion and the thick film resistor portion, are fired in different atmospheres and are then bonded to each other by soldering. In this case, the semiconductor integrated element 1 of the package 2 is assembled at a temperature of about 350°C, whilst the soldering temperature is about 200°C, which temperature, accordingly, does not affect the assembled semiconductor integrated circuit element 1.

Usually, during testing of the integrated circuit element 1, it is impossible to adjust the resistance values of resistors within the element 1. Therefore, the circuit constants of the element 1 are modified by trimming the resistor pattern 7 on the operating condition of the element 1. As a result, desired characteristics of the element 1 are obtained. Such trimming is called "function" trimming. In the present invention, trimming, particularly function trimming, can be easily carried out. Probes (not shown) are connected to the external connection terminals 5 so as to operate the device of Fig. 1. In this operating state, the resistance value of the thick film resistor pattern 7 is adjusted precisely to a desired value by a laser trimming unit in which the amount of trimming is controlled by a computer. Thus, the optimum resistance value for the device is obtained.

In Fig. 3, trimming in a direction "a" crossing the resistor pattern 7 greatly reduces the resistance value thereof, whilst trimming in a direction "b" parallel to the resistor pattern 7 reduces the resistance value thereof only a little. The two directions of trimming can be controlled to obtain a desired resistance value by using a computer.

As explained hereinbefore, the hybrid integrated circuit device according to the present invention is advantageous as compared with the prior art in that the device is small, testing can be easily carried out since the resistor pattern 7 is mounted on the package 2, the device can operate without a printed board, and precise function trimming of the resistor pattern 7 can be more easily carried out.

Note that it is preferable that a resistor electrically associated with the semiconductor integrated circuit element 1 be arranged as close to the element 1 as possible. In view of this, the present invention is also advantageous as compared with the prior art.

## Claims

1. A hybrid integrated circuit device comprising a semiconductor integrated circuit element (1) mounted within a multilayer ceramic package (2), characterised in that the package includes a first frame member (2—4) creating a cavity (3) for incorporating the semiconductor circuit element therein, a cap (2—6) mounted on the first frame member so as to seal the cavity, and a second frame member (2—5) mounted on the first frame member and surrounding the cap, the cap being thinner than the second frame member; external connection terminals (5) are mounted on the back of the multilayer ceramic package; a base (6) is mounted on the second frame member; and a film resistor pattern (7) is formed on the outer surface of the base and electrically connected to the semiconductor circuit element, the film resistor pattern being trimmed so that the resistance value of the film resistor pattern is adapted to the characteristics of the semiconductor circuit element.

2. A device as claimed in Claim 1, characterised in that the multilayer ceramic package (2) is manufactured by coating the surface and/or throughholes of a raw ceramic sheet (2—1 ... 2—5) with a layer of molybdenummanganese and then laminating the raw ceramic sheets, which are then fired in a reducing atmosphere.

3. A device as claimed in Claim 1 or Claim 2, characterised in that the film resistor pattern (7) is manufactured by coating the base (6) with a mixture of oxide and glass powder and then firing it in an oxidising atmosphere.

4. A device as claimed in Claim 3, characterised in that the oxide comprises ruthenium oxide.

## Patentansprüche

1. Integrierte Hybridschaltungsvorrichtung mit einem integrierten Halbleiterschaltungselement (1), welches innerhalb einer vielschichtigen Keramikpackung (2) angeordnet ist, dadurch gekennzeichnet, daß die Packung ein erstes Rahmenteil (2—4) umfaßt, welches einen Hohlraum (3) zur Aufnahme des Halbleiterschaltungselementes schafft, eine Kappe (2—6), die auf dem ersten Rahmenteil montiert ist, um den Hohlraum so abzudichten, und ein zweites Rahmenteil (2—5), das auf dem ersten Rahmenteil montiert ist und die Kappe umgibt, welche dünner als das zweite Rahmenteil ist; externe Verbindungsanschlüsse (5) auf der Rückseite der vielschichtigen Keramikpackung angeordnet sind; die Basis (6) auf dem zweiten Rahmenteil montiert ist; und ein Filmwiderstandsmuster (7) auf der äußeren Oberfläche der Basis gebildet und elektrisch mit dem Halbleiterschaltungselement verbunden ist, welches Filmwiderstandsmuster so getrimmt ist, daß der Widerstandswert des Filmwiderstandsmusters an die Charakteristiken des Halbleiterschaltungselementes angepaßt ist.

2. Vorrichtung nach Anspruch 1, dadurch gekennzeichnet, daß die mehrschichtige Keramikpackung (2) durch Überziehen der Oberfläche und/oder Durchgangslöcher eines rohen Keramikblattes, (2—1 ... 2—5) mit einer Schicht aus Molybdenmangan und durch anschließendes Laminieren der rohen Keramikblätter hergestellt ist, die dann in einer reduzierenden Atmosphäre gebrannt werden.

3. Vorrichtung nach Anspruch 1 oder 2, dadurch gekennzeichnet, daß das Filmwiderstandsmuster (7) durch Überziehen der Basis (6) mit einer Mischung aus Oxyd und Glaspulver und anschließendes Brennen in einer oxydierenden Atmosphäre hergestellt ist.

4. Verfahren nach Anspruch 3, dadurch gekennzeichnet, daß das Oxyd Rutheniumoxyd umfaßt.

## Revendications

1. Dispositif à circuit intégré hybride comprenant un élément de circuit intégré semiconducteur (1) monté à l'intérieur d'un boîtier de céramique multicouche (2), caractérisé en ce que le boîtier comporte un premier élément de bâti (2—4) créant une cavité (3) destinée à loger l'élément de circuit semiconducteur, un couvercle (2—6) monté sur le premier élément de bâti de manière à fermer hermétiquement la cavité, et un deuxième élément de bâti (2—5) monté sur le premier élément de bâti et entourant le couvercle, le couvercle étant plus mince que le deuxième élément de bâti; des bornes de connexion externes (5) sont montées sur le dos du boîtier de céramique multicouche; une base (6) est montée sur le deuxième élément de bâti; et une configuration de résistance pelliculaire (7) est formée à la surface extérieure de la base et est électriquement connectée à l'élément de circuit semiconducteur, la configuration de résistance pelliculaire étant ajustée par découpage de façon que la valeur dce résistance de la configuration de résistance pelliculaire soit adaptée aux caractéristiques de l'élément de circuit semiconducteur.

2. Dispositif selon la revendication 1, caractérisé en ce que le boîtier de céramique multicouche (2) est fabriqué par revêtement de la surface et, ou bien, des trous passants d'une feuille de céramique crue (2—1, ..., 2—5) au moyen d'une couche de molybdène-manganèse, puis par réalisation d'un stratifié des feuilles de céramique crue, lesquelles sont ensuite cuites en atmosphère réductrice.

3. Dispositif selon la revendication 1 ou 2, caractérisé en ce que la configuration de résistance pelliculaire (7) est fabriquée par revêtement de la base (6) au moyen d'un mélange d'oxyde et de poudre de verre, puis par cuisson de celle-ci en atmosphère oxydante.

4. Dispositif selon la revendication 3, caractérisé en ce que l'oxyde comprend l'oxyde de ruthénium.

# Fig. I

## Fig. 2

## Fig. 3